# EUROPEAN PATENT APPLICATION

(11) **EP 4 180 845 A1**
(43) Date of publication of application: **17.05.2023**
(21) Application number: 21207769.7
(22) Date of filing: 11.11.2021
(51) Int. Cl.: G01T 1/24, H01L 31/00

(54) **RADIATION DETECTOR WITH LASER CUT ABSORBER TILES**

(71) Applicant: Siemens Healthcare GmbH, 91052 Erlangen (DE)
(72) Inventor: Deumel, Sarah, 91054 Erlangen-Sieglitzhof (DE); Tedde, Sandro Francesco, 91085 Weisendorf (DE); Hürdler, Judith Elisabeth, 90409 Nürnberg (DE)

(57) **Abstract**

The present invention relates to a detector for electromagnetic radiation, particularly an X-ray and/or gamma detector, comprising a first, pixelated electrode layer comprising a multitude of electrode pixels, a first layer comprising a multitude of tiles comprising a material absorbing and converting the electromagnetic radiation, wherein at least edges of tiles facing another tile have been cut using pulsed laser cutting, and a second electrode layer, as well as a method of producing such a detector.

The project leading to this application has received funding from the European Union's Horizon 2020 research and innovation programme under grant agreement No 871336.

## Description

The present invention relates to a detector for electromagnetic radiation, particularly an X-ray and/or gamma detector, comprising a first, pixelated electrode layer comprising a multitude of electrode pixels, a first layer comprising a multitude of tiles comprising a material absorbing and converting the electromagnetic radiation, wherein at least edges of tiles facing another tile have been cut using pulsed laser cutting, and a second electrode layer, as well as a method of producing such a detector.

The project leading to this application has received funding from the European Union's Horizon 2020 research and innovation programme under grant agreement No 871336.

For pixelated radiation detectors, particularly X-ray and/or gamma detectors, usually the production of large detector surfaces is necessary. A particular difficulty is the production of large absorber layers as direct conversion layers, particularly comprising or made of perovskite, but also the same or similar problems exist in the production of large absorber layers comprising or made of other direct conversion materials like CdTe, CdZnTe, GaAs, a-Se, HgI₂, PbO, Si, TlBr, etc.

A method of producing large detector surfaces is e.g. disclosed in EP 21165773.9, to which is made reference, and which discloses radiation detectors with butted absorber tiles with minimized dead areas. The method disclosed therein is based on tiling of smaller absorber layer parts on a, e.g. pixelated, backplane. Empty areas between the parts then can be filled with a semiconductor and/or a perovskite, thus minimizing or even deleting areas without detector signal between the different parts. Tiling therein has the advantage that not only larger detector areas can be produced, but also that varying detector geometries, e.g. with curvatures, can be produced more easily.

When producing the absorber layer parts, there still exists a further problem in particular production methods thereof. Absorber layers (hereinafter also called layers comprising a material absorbing and converting electromagnetic radiation), particular those comprising perovskite or consisting of perovskite, but also those comprising or consisting of other direct conversion materials, usually are produced by a so-called soft-sintering of powders comprising the absorber material in order to produce layers of absorber material that can be handled independently, particularly as thicker absorber layers are needed for efficient radiation detection. Such independent (also considered free-standing) absorber layers, e.g. perovskite layers, are usually extremely brittle, and handling thereof is usually becoming more complicated the larger the area of the produced absorber layer is. In order to produce detector areas of any size, normally parts of the absorber material, e.g. with varying measurements, are combined. For obtaining spaces between these different parts as small as possible, rectangular edges of the absorber layer parts are preferred, e.g. by tiling together rectangular or square tiles. It is, however, technically difficult to produce such edges with absorber layers having a thickness of several hundred micrometers, as e.g. required for sufficient radiation detection.

During soft-sintering of angular absorber layers furthermore it was found that edge areas with thicknesses of several hundred micrometers can show different compression, e.g. based on pressure differences and/or powder filling differences during production. Due to these differences, different areas in edges may occur that can show different, e.g. also diminished, radiation absorption and thus varying signal in comparison to the center of the absorption layer. Particular at corners these problems, e.g. due to differences in applied pressure, these variations may become significant. In addition, also material loss may occur at edges, resulting e.g. in significant roughness at the edges, making tiling without spaces between more difficult.

A further problem that may occur is when tiles are removed from a pressing tool. At such times it may occur that parts of the powder adhere to edges of the angular forms, and thus parts with frayed edges or even with breakages can only be obtained when removing the layer from the tool.

For easier removal of layers from the pressing tool, better pressure distribution and thus densification usually round pressing tools are applied. The resulting parts cannot be easily tiled due to the geometry thereof, though.

In order to change the geometry of e.g. round layers to angular layers that can be tiled, mechanical processes can be applied. For example, cutting of perovskite layers with a diamond thread is described in Liu et al. https://doi.org/10.1002/adom.201600327. While the method was applied to single crystalline material, application to polycrystalline material resulted in breaking of pieces at edges.

Other methods of forming e.g. perovskite are the targeted growth of crystals on a given structure, as described by Yang et al. https://doi.org/10.1002/smtd.201800110, and applying technologies like lithography, as described by Bar-On et al. https://doi.org/10.1002/admt.201800212, for example. While the former is only applicable to the production of crystals on small surfaces - not being applicable to soft-sintering of powders, the latter usually results in a chemical and/or morphological change of the absorber layer due to a significant amount of energy applied and/or the usage of etching agents and solvents.

There thus is a need for an improved method of producing a detector for electromagnetic radiation in which tiling of absorber layers can be carried out easily, and in which improved signal detection is possible.

The inventors found that edges of tiles comprising a material absorbing and converting the electromagnetic radiation can be suitably cut using pulsed laser cutting, thereby minimizing the amount of energy introduced around the material cut at the edge, and thus minimizing change in the chemical composition of the material absorbing and converting the electromagnetic radiation. At the same time, the laser pulses are sufficient to suitably remove the material within the focus of the laser, achieving cutting of layers of such material absorbing and converting the electromagnetic radiation with a thickness of several hundred micrometers and even millimeters, and achieving a vertical cut.

In addition, laser cutting allows realizing any suitable geometry of the tiles, so that these can be adapted to any detector or also pixel sizes of e.g. a backplane. Using a laser, precision of the edge in the area of a few micrometers can be achieved, which is far below the pixel size of a detector the tiles are used in, e.g. of about 50 - 300 µm, thus minimizing inhomogeneities, i.e. areas with different sensitivities, in the detected signal, e.g. an X-ray image

In a first aspect, the invention relates to a detector for electromagnetic radiation, particularly an X-ray and/or gamma detector, comprising:
- a first, pixelated electrode layer comprising a multitude of electrode pixels,
- a first layer comprising a multitude of tiles comprising a material absorbing and converting the electromagnetic radiation, wherein at least edges of tiles facing another tile have been cut using pulsed laser cutting, and
- a second electrode layer.

Furthermore disclosed is a method of producing a detector for electromagnetic radiation, particularly an X-ray and/or gamma detector, comprising:
- providing a first, pixelated electrode layer comprising a multitude of electrode pixels,
- optionally applying a second layer on the first, pixelated electrode layer, wherein the second layer is an adhesion promoting layer, preferably wherein the second layer comprises at least a third semiconductor and/or a conductor and/or a third perovskite,
- preparing a multitude of tiles comprising a material absorbing and converting the electromagnetic radiation,
- cutting at least part of edges of the tiles comprising a material absorbing and converting the electromagnetic radiation using pulsed laser cutting, particularly edges that will be facing each other during further production of the detector,
- applying the multitude of tiles comprising a material absorbing and converting the electromagnetic radiation on the first, pixelated electrode layer or on the optional second layer, particularly in a way that edges cut by pulsed laser cutting are facing each other, and
- applying a second electrode layer, on the first layer.

Further aspects and embodiments of the invention are disclosed in the dependent claims and can be taken from the following description, figures and examples, without being limited thereto.

The enclosed drawings should illustrate embodiments of the present invention and convey a further understanding thereof. In connection with the description they serve as explanation of concepts and principles of the invention. Other embodiments and many of the stated advantages can be derived in relation to the drawings. The elements of the drawings are not necessarily to scale towards each other. Identical, functionally equivalent and acting equal features and components are denoted in the figures of the drawings with the same reference numbers, unless noted otherwise.
Figure 1 shows an X-ray absorption measurement of a sample line of an edge of perovskite material obtained by pressing a rectangular sample tile in comparison to an optimal edge.
Figures 2 to 5 depict schematically possible edges that can be theoretically obtained by methods of the prior art.
In Figures 6 to 10 edge geometries that can be obtained and realized according to the present invention are schematically shown.
Figure 11 schematically presents a detector with inhomogeneous edges of different absorber tiles according to the state of the art.
In contrast, an exemplary detector with reduced space between the absorber tiles is schematically shown in Figure 12.
Figures 13 to 15 show schematically examples of different assembly possibilities of absorber tiles in detectors of the present invention with the possibility to reduce spacing between the tiles.
Figures 16 and 17 schematically depict possible laser cut geometries based on a circular pressed wafer.
Figure 18 schematically shows a method of the present invention.
Figures 19 and 20 present an image of a laser cut wafer and the schematic for the cut.
Figure 21 shows SEM images of the cut shown in Figure 19.
Figures 22 and 23 present measurement data of a compositional analysis of laser cut perovskite samples in comparison to a reference sample, and Figures 24 and 25 show SEM images of the reference sample and the laser cut, respectively.
Figures 26 and 28 show data of upper secondary electron in-lens (SEI) measurement data of laser cut and broken MAPI samples, respectively, and Figures 27 and 29 lower secondary electron in-lens (LEI) measurement data thereof.

### Detailed description of the present invention

Unless defined otherwise, technical and scientific terms used herein have the same meaning as commonly understood by one of ordinary skill in the art to which this invention belongs.

Amounts within the present invention are given in wt.%, unless stated otherwise or clear from context.

In the present disclosure, a reference to a conductive material refers to an electrically conductive material, unless clearly stated otherwise.

Before the invention is described in exemplary detail, it is to be understood that this invention is not limited to the particular component parts of the process steps of the methods described herein as such methods may vary. It is also to be understood that the terminology used herein is for purposes of describing particular embodiments only, and is not intended to be limiting. It must be noted that, as used in the specification and the appended claims, the singular forms "a," "an" and "the" include singular and/or plural referents unless the context clearly dictates otherwise. For example, the term "a" as used herein can be understood as one single entity or in the meaning of "one or more" entities. It is also to be understood that plural forms include singular and/or plural referents unless the context clearly dictates otherwise. It is moreover to be understood that, in case parameter ranges are given which are delimited by numeric values, the ranges are deemed to include these limitation values.

In a first aspect, the present invention relates to a detector for electromagnetic radiation, particularly an X-ray and/or gamma detector, comprising:
- a first, pixelated electrode layer comprising a multitude of electrode pixels,
- a first layer comprising a multitude of tiles comprising a material absorbing and converting the electromagnetic radiation, wherein at least edges of tiles facing another tile have been cut using pulsed laser cutting, and
- a second electrode layer.

Particularly, the first layer is arranged between the first, pixelated electrode layer and the second electrode layer.

The present detector can particularly detect X-ray and/or gamma radiation, but preferably at least detects X-rays or particularly detects X-rays, i.e. is an X-ray detector according to certain embodiments.

In the detector the first, pixelated electrode layer comprising a multitude of electrode pixels is not particularly restricted. The number of electrode pixels is not particularly restricted but is at least 2. According to certain embodiments, the number of electrode pixels, respectively pixels, per row, is between and including 2 and 10000, e.g. between and including 2 and 1000, e.g. between and including 2 and 100. This leads for e.g. square detectors to a number of electrode pixels of e.g. 2 x 2 to 10000 x 10000, e.g. 3000 x 4000.The first, pixelated electrode layer comprises at least 2 pixels, i.e. 2 or more, e.g. 3, 4, 5, 6, 7, 8, 9, 10, or more. The electrode pixels can be suitably contacted electrically. Neither the pixel size nor the material of the electrode pixels is particularly restricted, and those applied in detectors for electromagnetic radiation can be suitably applied. An electrode pixel can have a pitch of 98 µm of a square electrode pixel, but can also have any other size. The material of the electrode pixel is not particularly restricted and may comprise a conductive metal oxide, a conductive polymer and/or a metal, which serves for detection of e.g. an electron or a hole produced in the first layer.

The first, pixelated electrode layer may comprise a substrate on which the electrode pixels may be suitably arranged. The substrate, which may also be called backplane, is not particularly restricted and may be made of a material like glass, silicon, plastic, etc. For contacting the electrode pixels there may be transistors and/or electric connections for each separate pixel, the transistors being e.g. made of a-Si, IGZO or based CMOS technology, etc. The backplane also may include a lower electrode, passivation layers, e.g. comprising oxides and/or nitride, optionally anchor structures / grids, etc.

In addition, also the second electrode layer is not particularly restricted. It may comprise an electrically conductive material, e.g. a conductive metal oxide, a conductive polymer, and/or a metal. According to certain embodiments, the second electrode layer may be arranged planar. According to certain embodiments, the second electrode layer is at least partially or even totally transparent for the electromagnetic radiation to be detected, e.g. X-ray (wavelength ≥ 10 pm and < 10 nm) and/or gamma radiation (wavelength < 10 pm). For example, the second electrode layer may comprise indium tin oxide (ITO), aluminium zinc oxide (aluminium doped zinc oxide, AZO), antimony tin oxide (ATO) and/or fluorine tin oxide (FTO) as electrode material, or consist thereof.

In the detector the respective electrode may be suitably connected as anode or cathode.

According to certain embodiments, a surface layer, e.g. glass and/or an encapsulation, may be arranged on the second electrode layer, opposite to the first layer, for protection, which is not particularly restricted. This can be suitably formed.

Also, the first layer comprising a multitude of tiles comprising a material absorbing and converting the electromagnetic radiation, wherein at least edges of tiles facing another tile have been cut using pulsed laser cutting, is not particularly restricted, as long as at least edges of tiles facing another tile have been cut by pulsed laser cutting. While it is not excluded that only edges of tiles facing another tile are cut by pulsed laser cutting, according to certain embodiments all edges of the tiles have been cut by pulsed laser cutting, this way also enabling a homogeneous signal at the edge of the detector. The first layer may be produced as a free-standing layer, but also may be produced not as a free standing layer, e.g. in contact with an electrode, e.g. an ITO- or FTO-electrode on a suitable substrate, e.g. glass.

According to certain embodiments, the first layer particularly consists only of the tiles and optionally a material filling gaps between tiles.

The tiles comprising a material absorbing and converting the electromagnetic radiation in the first layer are not particularly restricted. They can be of regular, e.g. square or rectangular, shape, but can also have any other shape, or may also be irregular. According to certain embodiments, they are square and/or rectangular, so that they can be arranged regularly and as close as possible so that gaps between them can be minimized or even avoided.

In the present detector, the size of the tiles in the first layer is not particularly restricted. According to certain embodiments, the tiles have a size in the range of 1x1 cm² to 50x50 cm², preferably between and including 5x5 cm² to 50x50 cm², further preferably between and including 10x10 cm² to 50x50 cm². With these sizes a good manufacturing of the tiles is warranted, while at the same time a good conversion in the absorption layer is achieved. Particularly, with such size soft-sintering of the tiles, particularly if they comprise at least a first perovskite, is possible, and they can be easily attached. A smaller size of the tiles also enables using particularly smaller presses and tools for manufacturing thereof.

Furthermore, the thickness of the tiles is not particularly restricted and can be e.g. between and including 10 µm to 50000 µm, preferably between and including 25 to 10000 µm, further preferably between and including 50 µm to 3000 µm, further preferably between and including 70 µm to 2000 µm, even further preferably between and including 100 µm and 1500 µm, e.g. between and including 100 µm and 1000 µm.

According to certain embodiments, the tiles have a size in the range of 1x1 cm² to 50x50 cm² and a thickness of between and including 10 µm to 50000 µm.

According to certain embodiments, the number of tiles in the first layer is between and including 2 and 1000, preferably between and including 2 and 100, more preferably between and including 2 and 50, even more preferably between and including 2 and 10.

According to certain embodiments, two adjacent tiles in the first layer have a tilt angle between tiles between and including 0° and 5°, so that gaps between them are further minimized.

In the tiles, the material absorbing and converting the electromagnetic radiation is not particularly restricted, and the tiles may comprise one or more of such materials, or may consist of one or more of such materials. For example, the material absorbing and converting the electromagnetic radiation may comprise a scintillator or even consist of the scintillator, e.g. for detecting gamma radiation, the scintillator e.g. being selected from the list consisting of CsI:Tl - thallium doped cesium iodide, terbium doped gadolinium oxy-sulfids, barium fluoride (BaF₂), bismuth germanate (BGO), be-ryllium fluoride (BeF₃), quantum dots, scintillating perovskite nanocrystals (the perovskite being chosen from those described with regard to the first perovskite), etc. Alternatively or in addition, the material absorbing and converting the electromagnetic radiation is a first semiconductor and/or a first perovskite. According to preferred embodiments, the material absorbing and converting the electromagnetic radiation is at least a first semiconductor and/or a first perovskite, particularly at least a first perovskite, also comprising mixtures of two or more first perovskites, and particularly is a first perovskite.

The first semiconductor is not particularly restricted and may include at least one of mercury(II) iodide (HgI₂), lead(II) iodide (PbI₂), bismuth triiodide (BiI₃), thallium bromide (TlBr), lead(II) oxide (PbO), cadmium telluride (CdTe), cadmium zinc telluride (CdZnTe), amorphous selenium (a-Se), Gallium Arsenide (GaAs), and/or silicon (Si). However also organic-inorganic semiconducting perovskites can be semiconductors and thus can be also considered as first semiconductor, but according to certain embodiments are not contained.

Also, the first perovskite is not particularly restricted and may contain any organic, inorganic and/or organic-inorganic perovskite, as well as mixtures thereof. For example, suitable pervoskites are described in WO 2014045021 A1, which is referred to with regard to perovskites. The perovskite may have an ABX structure, e.g. ABX₃ structure, with one or more A cations, one or more B cations, and one or more anions X, particularly chosen from chalcogenides and/or halogenides, particularly halogenides, wherein
the A and B cations may be organic and/or inorganic - A being particularly an organic cation chosen from alkyl, aryl, aralkyl, alkylaryl, alkenyl and/or alkinyl ammonium groups (i.e. with one, two, three, or four identical or different residues, including the organic residues and H, in the ammonium group), e.g. with 1 to 60 C atoms, and B being particularly an inorganic cation chosen particularly from cations, particularly divalent cations, of metals like Ca, Sr, Cd, Cu, Ni, Mn, Fe, Co, Pd, Ge, Sn, Pb, and lanthanides like Yb, Gd, Eu,
suitable chalcogenides include oxide, sulfide, selenide, telluride, and
suitable halogenides include e.g. F⁻, Cl⁻, Br⁻, I⁻, particularly Cl⁻, Br⁻, I⁻.

Suitable examples of perovskites as first perovskite include e.g. MAPbI₃ (CH₃NH₃PbI₃), MAPbBr₃ (CH₃NH₃PbBr₃), FAPbI₃ (HC(NH₂)₂PbI₃), MAPbICl₂ (CH₃NH₃PbICl₂), FAPbBr₃ (HC(NH₂)₂PbBr₃), EAPbI₃ (CH₃CH₂NH₃PbI₃), PAPbI₃ (CH₃CH₂CH₂NH₃PbI₃) , BA₂PbI₄ ((CH₃CH₂CH₂CH₂NH₃)₂PbI₄) , PMA₂PbI₄ ((C₆HₛCH₂NH₃) ₂PbI₄) , PEA₂PbI₄ ((C₆H₅CH₂CH₂NH₃) ₂PbI₄) , EAPbBr₃ (CH₃CH₂NH₃PbBr₃) , PAPbBr₃ (CH₃CH₂CH₂NH₃PbBr₃) ; further mixed halogenides thereof; inorganic-organic perovskites with a mixture of A-cations with halogenides X (X = Cl, Br, I), e.g. MAFAPbX₃ (MA = CH₃NH₃, FA = HC(NH₂)₂), MAGAPbX₃ (GA = guanidinium), BAPAPbX₃ (BA = CH₃CH₂CH₂CH₂NH₃, PA = CH₃CH₂CH₂NH₃) , etc.; organic halogenated mixtures, in which the halogens may be partially substituted by other halogens, e.g. halogenides of formula I₃₋ₓClₓ or Br₃₋ₓClₓ, etc., e.g. MAPbI₃₋ₓClₓ or CH₃NH₃PbBr₃₋ₓClₓ); organic and/or inorganic perovskites where Pb at least partially or even totally is substituted by Sn, Cu, Ni, Bi, Co, Fe, Mn, Cr, Cd, Ge and/or Yb, and/or mixtures thereof; inorganic perovskites and mixtures thereof, e.g. CsPbX₃, wherein X = Cl, Br, and/or I, as well as mixtures thereof (e.g. CsPbBr₃, CsPbI₃, CsPbCl₃), Cs₃Bi₂X₉, wherein X = Cl, Br, and/or I, as well as mixtures thereof, Cs₃Sb₂X₉, wherein X = Cl, Br, and/or I, as well as mixtures thereof, Cs₂AgBiX₆, wherein X = Cl, Br, and/or I, as well as mixtures thereof, Rb₃Bi₂X₉, wherein X = Cl, Br, and/or I, as well as mixtures thereof, Rb₃Sb₂X₉, wherein X = Cl, Br, and/or I, as well as mixtures thereof, CsSnI₃; etc., as well as mixtures of the perovskites.

According to certain embodiments, the tiles in the first layer comprise at least a first semiconductor and/or a first perovskite, preferably at least a first perovskite, as the material absorbing and converting the electromagnetic radiation. Particularly, the edges of the first perovskite can be cut sufficiently using pulsed laser cutting.

In the first layer, at least edges of tiles facing another tile have been cut using pulsed laser cutting. According to certain embodiments, all edges of the tiles in the first layer have been cut using pulsed laser cutting. With the pulsed laser cutting, not only straight edges of the tiles can be achieved according to certain embodiments. According to certain embodiments, the edges of the tiles are cut essentially vertically to the major surfaces of the tiles, i.e. being at an angle to the major surfaces of at least 85°, preferably at least 88°, more preferably at least 89°, even more preferably at least 89.5°. Particularly preferably, the edges are cut at an angle of 90° in relation to the major surfaces of the tiles, i.e. they are vertical. However, it is not excluded that there is a deviation from 90°, e.g. when the detector is to be curved.

According to certain embodiments, the respective edges are cut essentially straight, i.e. show a low surface roughness of only a few micrometers along the cut, e.g. less than 20.0 µm, e.g. less than 10.0 µm, e.g. less than 5.0 µm, e.g. 2.0 µm or less, e.g. 1.5 µm or less, e.g. 1.0 µm or less. It has particularly been observed that the mean particle/crystal size decreases in the cut region in comparison to the bulk region, where no influence of the laser occurs, having e.g. particle sizes of about 2 µm or more in the bulk, and particle sizes of 1 µm or less in the cut region. It is assumed that a recrystallization in the cut region occurs with a smaller crystal size. The measurement of surface roughness is not particularly restricted. Particle sizes and/or surface roughness can be e.g. obtained by optical and/or SEM (scanning electron microscopy) imaging together with image analysis, but also other surface roughness measurements including other optical measurement methods and/or tactile methods are feasible. Compared to other method, the pulsed laser cutting allows a higher accuracy, thus reducing empty spaces, respectively dead zones, between tiles, resulting in improved image quality of the detector.

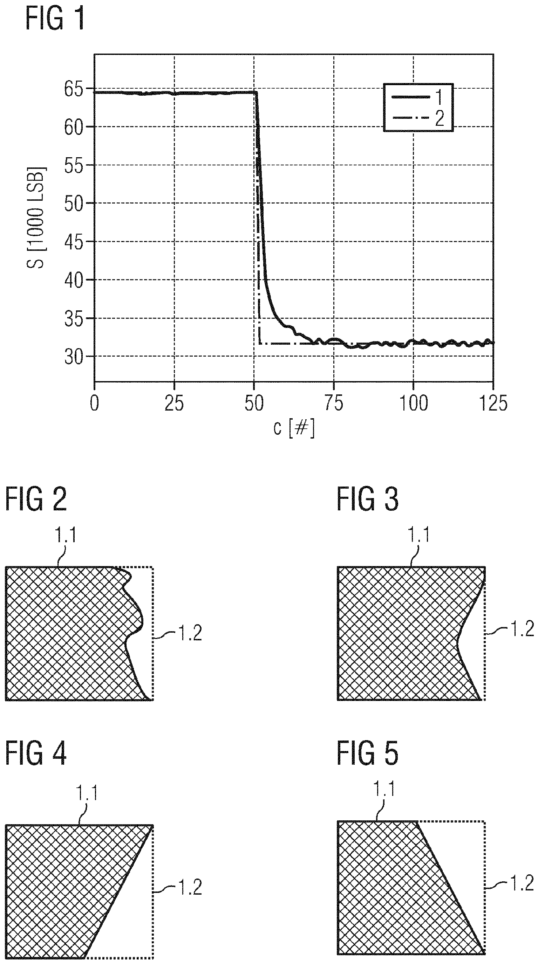

The pulsed laser cutting particularly improves the straightness of tiles, particularly in the case of angular tiles, e.g. rectangular or square tiles, compared to a state just after production. This is e.g. shown in Figure 1, where the real edge 1 of a tile made of MAPI and pressed with a rectangular pressing tool is shown in comparison to the ideal sharp shape edge 2 (dotted line). The real edge 1 therein is observed with an indirect X-ray detector (Xineos-2222HS from Teledyne DALSA with a pixel pitch of 152µm, 16 Bit ADC, CsI:Tl scintillator) based on CMOS-technology. The X-ray signal shows the capacity of X-ray absorption of the MAPI wafer, and Figure 1 shows the signal s (given in 1000 LSB) plotted against the column number c on the x-axis, clearly showing that the real edge 1 shows a round course (black line) instead of the ideal sharp shape edge 2. In the figure, the Y-axis is given in LSB, which is last significant bit. It is the smallest step of the analog to digital converter. A 16 Bit flat panel detector was used for acquiring an X-ray image of a MAPI pellet (0 LSB would mean no X-ray, 2^16= 65536 LSB the highest detectable signal before saturation. What is shown in the Figure is the signal profile for one row and several columns (in this case pixels). On the left part of the figure, high values of signals are recorded due to the absence of MAPI. On the right side, the signal drops to ∼30000 LSB, meaning that the MAPI absorbed ∼50% of the impinging dose. At the edge of the MAPI layer, the absorption of the Pellet is not a 90 deg step, but rather a smooth transition, indicating an inhomogeneous density of the material close to the border of the MAPI. Since the values on the x-Axis are pixels and the pixel pitch was 152µm, it takes ∼20 pixels (∼3mm) to show a constant absorption.

Furthermore, also additional problems were observed with the pressed wafers (data not shown). Particular, inhomogeneities were observed at the edges, as well as crumbling of powder. Also, a lower densification of up to 10% was observed at edges, and particularly at corners, which leads to a reduced X-ray signal. While such differences are less pronounced in circular pressed tiles, circular pressed tiles have a disadvantage in that they cannot be placed easily next to each other, leaving huge free spaces between round tiles. As particularly thick tiles, e.g. in X-ray or gamma detectors, are usually only available economically via pressing with good homogeneity, the cutting of the edges thus enables a suitable tool for improved image quality in the final detector.

Upon pulsed laser cutting, straight edges were observed (further details shown in examples), with improved signal and homogeneity. Using pulsed laser cutting, also differences could be observed in edge quality and structure not only compared to the original edges obtained in the pressing tool, but also compared to other artificially produced edges, e.g. produced via breaking off or cutting off, e.g. also with a continuous laser.

Figures 2 to 5 schematically show cross-views of sample edges produced by different cutting/shaping methods. The dotted lines show the desired edge shape 1.2 of the sample, while the black lines show the obtained edge shapes 1.1 obtained with different methods.

If the absorber layer is soft sintered in an angular pressing tool, powder lumps adhere to the tool and tear out. This results in an inhomogeneous edge, as shown in Figures 2 and 3. With other methods like lithography and etching procedures, a sloping structure cannot be ruled out, as shown in Figures 4 and 5. In contrast, with the pulsed laser approach, the desired straight shape is reached easily.

The pulsed laser-cut edges showed improved porosity as well as no structural changes of the material absorbing and converting the electromagnetic radiation (which can be observed when cutting with a continuous laser due to high-energy input). Surprisingly, such improved structure can be obtained even when cutting through thick layers of tiles with thicknesses in the range of several hundred micrometers to several millimeters, and a vertical cut is obtained with high cut precision and thus high precision of the edge in the range of only a few micrometers, e.g. far below the pixel size in the detector.

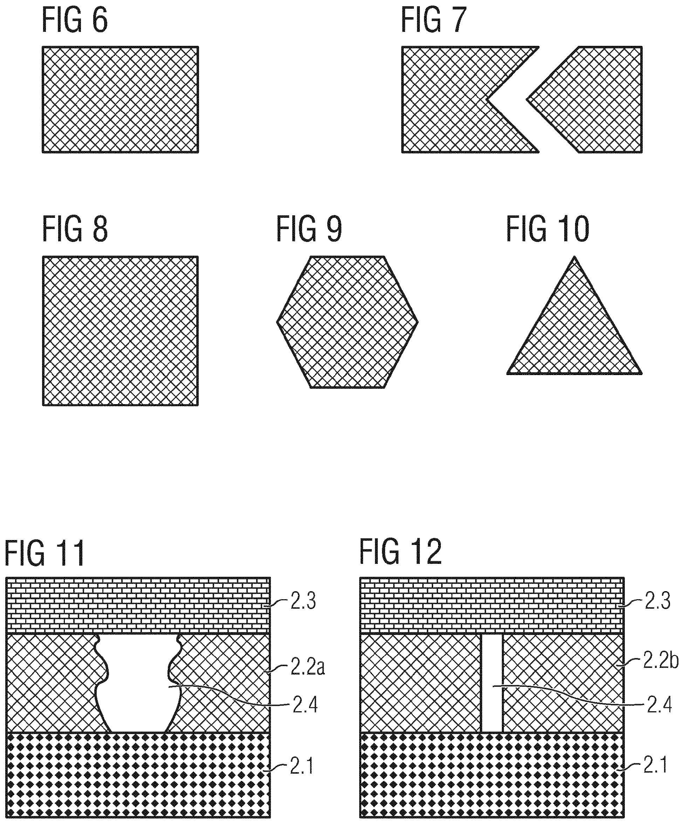

Another advantage that is obtainable with pulsed laser cutting of the edges is that the geometry of the sample can be varied widely, as can be seen in the views in Figures 6 to 10. In particular embodiments, it is also possible to think about cross-sections which are different from a sharp flat edge (∼90° angle), as shown in Figure 6, but rather working on a Key and Lock principle, where the two butting tiles have complementary edges, as shown in a cross-section in Figure 7. In addition, also other shapes of the tiles can be obtained (top views), e.g. square (Figure 8), hexagonal (Figure 9) or triangular (Figure 10) shapes, which can be suitably fit together in detectors, e.g. for specific observations and/or for variation in detector shape, e.g. flatness.

The effect of the different edges obtained by methods of the state of the art and by the present invention are shown schematically in Figures 11 and 12, indicating schematics of butted layer stacks with different shaped edges. In the two figures, exemplary detectors are shown with a first, pixelated electrode layer 2.1, e.g. on an active matrix backplane substrate (e.g. glass or silicon with a-Si, IGZO or CMOS TFT circuitry), with e.g. a bottom electrode per each pixel, a first layer 2.2a, 2.2b comprising a multitude of tiles (here two exemplary tiles) as a radiation converting layer (using e.g. semiconductors like CdTe, a-Se, Si, GaAs, Ge, HgI₂, PbO, semiconducting perovskites or others), and a second electrode layer 2.3 as a top electrode, with dead zones 2.4 between the tiles, i.e. the absorber layer is placed above an electrode in contact with an active-matrix backplane (not shown) and underneath a top electrode. Figure 11 therein shows a detector in line with the state of the art, with uneven, broken edges of the tiles in the first layer 2.2a, e.g. due to use of an angular pressing tool, whereas Figure 12 depicts a first layer 2.2b with tiles with pulsed laser cut, straight, sharp edges. When the classical approach is used (Figure 11), an inhomogeneous cutting edge is achieved. If two such edges are placed next to each other, the resulting spacing between them is big. In comparison, two laser cut absorber tiles with sharp edges (Figure 12) cause a small free spacing and therefore a smaller area with lower X-ray response, i.e. can achieve a reduction of the maximum spacing between tiles. It is noted that while in Figure 11 the tiles are shown with broken edges, the edges can also have any other uneven form in detectors of the state of the art, e.g. as in Figure 1 when a tile is applied for which the edge is not cut.

According to certain embodiments, the multitude of tiles are butted. With butted tiles, dead zones between the tiles can be minimized or even avoided, thus leading to an improved signal from the detector. Due to the cut edges, butting of the tiles in the detector of the invention is improved.

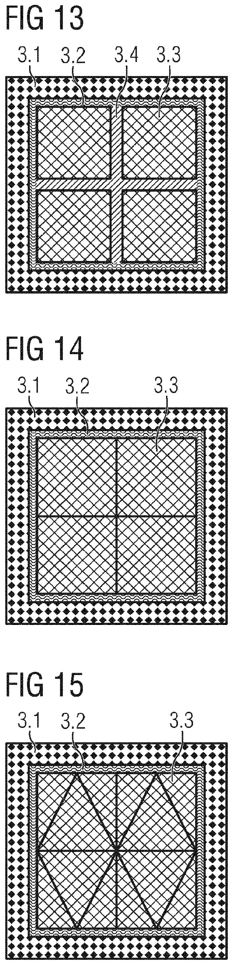

Exemplary different buttings of tiles are shown schematically in Figures 13 to 15, depicting exemplary butted imagers comprising an active-matrix backplane substrate 3.1 (e.g. glass or silicon with a-Si, IGZO or CMOS TFT circuitry) comprising a first electrode layer with e.g. a bottom electrode per each pixel, an optional second layer 3.2 as adhesion promoting layer (e.g. using a semiconductor), and tiles 3.3 (in the figures four exemplary tiles), here of an exemplary X-ray absorber material. A spacing 3.4 between the tiles - shown in Figure 13 - can be filled, e.g. with a semiconductor, e.g., recrystallized perovskite, as further described in the following, thus the spacing 3.4 filled with e.g. a recrystallized radiation converting layer (e.g. a semiconductor) (e.g. with time, temperature, atmosphere pressure). With the precision of the pulsed laser cutting, the spacing between the tiles can be reduced to nearly zero or even zero, as seen in Figure 14. In addition, different geometries of the tiles like triangles can be also achieved and used in the imager, as seen in Figure 15. The homogeneity of the X-ray detector can be increased by pulsed laser cutting of the absorber layers.

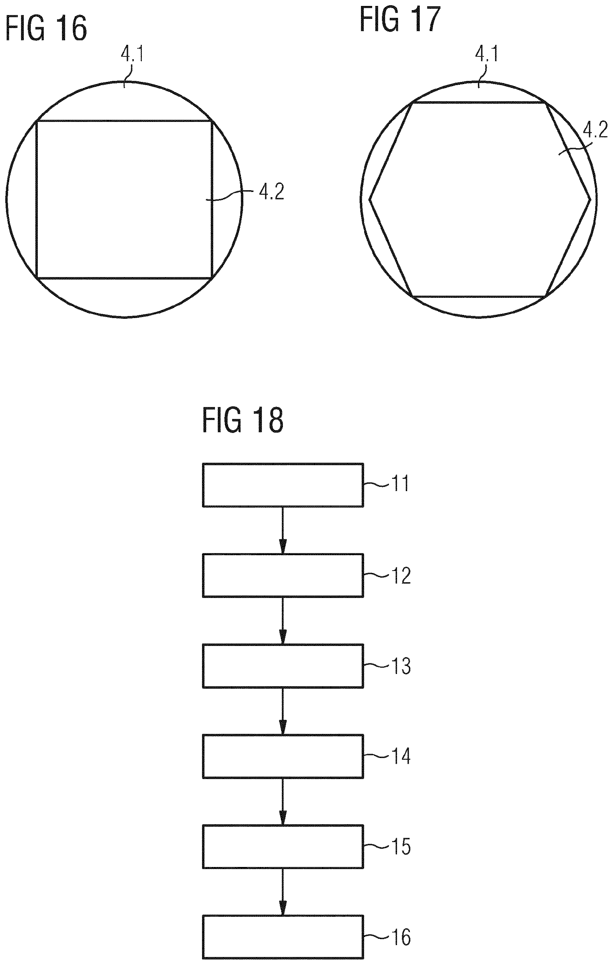

Cutting of different geometries also enables reduction of waste material, as shown schematically in Figures 16 and 17, representing schematics of possible laser cut geometries of laser cut absorber layers 4.2 based on a circular pressed wafer 4.1, e.g. being pressed as a soft-sintered absorber layer in a circular pressing tool. Exemplarily, it is possible to cut a square out of a circle, but the proportion of waste is high, as seen in Figure 16. With other geometries like hexagons, represented in Figure 17, the proportion of material which has to be recycled or wasted can be reduced.

According to certain embodiments, the detector further comprises at least one interlayer between the first, pixelated electrode and the first layer and/or between the first layer and the second electrode layer.

The interlayer therein is a layer that can function as an electron transport layer (respectively hole blocking layer (HBL)) or as a hole transport layer (respectively electron blocking layer (EBL)). The respective layers can be suitably set according to the charge of the respective electrodes, respectively electrode layers. The materials and thicknesses of any interlayers are not particularly restricted.

An exemplary electron transport layer (HBL) may comprise one or more of the following materials, e.g. with ≥ 30 wt.%, ≥ 50 wt.%, or ≥ 70 wt.%, in relation to the electron transport layer; essentially consist of one of more of these materials (e.g. with . ≥ 90 wt.%, ≥ 95 wt.%, or ≥ 99 wt.%, in relation to the electron transport layer; or even consist of at least one of these materials (wherein the following list is not exhaustive and also comprises mixtures as well as isomeric mixtures of the materials, e.g. binary, ternary, quaternary mixtures, etc.):
Fullerene derivatives like C60 PCBM ([6,6]-Phenyl C61 butyric acid methyl ester), C70 PCBM ([6,6]-Phenyl C71 butyric acid methyl ester), Bis-C60 PCBM (Bis-[6,6]-phenyl C61 butyric acid methyl ester), C60 oQDM (o-quinodimethane C60 mono adduct), Bis C60-oQDM (o-quinodimethane C60 bis adduct), ICMA (indene C60 mono adduct), ICBA (indene C60 bis adduct), fullerol (C60(OH)44); and other acceptors, comprising polymeric and small molecules like: dithienoindacene-based compounds like 3,9-bis(2-methylene-(3-(1,1-dicyanomethylene)-indanone))-5,5,11,11-tetrakis(4-hexylphenyl)-dithieno[2,3-d:2',3'-d']-s-indaceno[1,2-b:5,6-b']dithiophene (ITIC), IT-M (ITIC-M; 3,9-bis(2-methylene-((3-(1,1-dicyanomethylene)-6/7-methyl)-indanone))-5,5,11,11-tetrakis(4-hexylphenyl)-dithieno[2,3-d:2' ,3'-d']-s-indaceno[1,2-b:5,6-b']dithiophene), IT-DM (ITIC-DM; 3,9-bis(2-methylene-((3-(1,1-dicyanomethylene)-6,7-dimethyl)-indanone))-5,5,11,11-tetrakis(4-hexylphenyl)-dithieno[2,3-d:2',3'-d']-s-indaceno[1,2-b:5,6-b']dithiophene) and IDTBR ((5Z,5'Z)-5,5'-((7,7'-(4,4,9,9-Tetraoctyl-4,9-dihydro-s-indaceno[1,2-b:5,6-b']dithiophene-2,7-diyl)bis(benzo[c][1,2,5]thiadiazol-7,4-diyl))bis(methanylylidene))bis(3-ethylthiazolidin-2,4-dione)); perylenediimide-based compounds like TPB (tert-butylprydine, C₉H₁₃N), SdiPDI-Se (perylenediimide-derivative modified by insertion of selenophene units in the bay position), NIDCS-HO ((2E,2'E)-3,3'-(2,5-Bis(hexyloxy)-1,4-phenylene)bis(2-(5-(4-(N-(2-ethylhexyl)-1,8-naphthalimid)yl)-thiophen-2-yl)acrylonitrile)); diketopyrrolopyrrole-based compounds like DPP6 (dipeptidylaminopeptidase-like protein 6), 6,6'-(Benzo[c][1,2,5]thiadiazole-4,7-diylbis([2,2'-bithiophen]-5',5-diyl))bis(2,5-bis(2-ethylhexyl)-3-(thiophene-2-yl)-2,5-dihydropyrrolo[3,4-c]pyrrol-1,4-dione) (DTDfBT(DPP)2), 6,6',6'', 6'''-(9,9'-spirobi[fluorene]-2,2',7,7'-tetrayltetrakis(thiophene-5,2-diyl))tetrakis(2,5-bis(2-ethylhexyl)-3-(5-phenylthiophene-2-yl)-2,5-dihydropyrrolo[3,4- c]pyrrol-1,4-dione) (SF(DPPB)4); PFN (poly[(9,9-bis(3'-(N,N-dimethylamino)-propyl)-2,7-fluorene)-alt-2,7-(9,9-dioctylfluorene)]), PFN-OX (Poly[9,9-bis(60-(N,N-diethylamino)propyl)-fluorene-alt-9,9-bis-(3-ethyl(oxetane-3-ethyloxy)-hexyl)-fluorene]), PFO (poly(9,9-di-n-octylfluorenyl-2,7-diyl)), PPDIDTT (poly{[N,N'-bis(2-decyl-tetradecyl)-3,4,9,10-perylenediimide-1,7-diyl]-alt-(dithieno[3,2-b:2',3'-d]thiophene-2,6-diyl)}), TPBi (1,3,5-tris(N-phenylbenzimidazol-2-yl)benzene); metal oxides like TiOx, SnOx, IGZO, etc.

An exemplary hole transport layer (EBL) may comprise one or more of the following materials, e.g. with ≥ 30 wt.%, ≥ 50 wt.%, or ≥ 70 wt.%, in relation to the hole transport layer; essentially consist of one of more of these materials (e.g. with . ≥ 90 wt.%, ≥ 95 wt.%, or ≥ 99 wt.%, in relation to the hole transport layer; or even consist of at least one of these materials (wherein the following list is not exhaustive and also comprises mixtures as well as isomeric mixtures of the materials, e.g. binary, ternary, quaternary mixtures and/or blends, etc.):
poly(3-hexylthiophene-2,5-diyl) (P3HT), poly[2-methoxy-5-(2-ethylhexyloxy)-1,4-phenylenevinylene] (MEH-PPV), poly[2-methoxy-5-(3',7'-dimethyloctyloxy)-1,4-phenylenevinylene] (MDMO-PPV), CN-PPV, CN-MEH-PPV, other phthalocyanines, poly[(9,9-di-n-octylfluorenyl-2,7-diyl)-alt-(benzo[2,1,3]thiadiazol-4,8-diyl)] (F8BT), polyfluorene (PF), poly[2,1,3-benzothiadiazole-4,7-diyl[4,4-bis(2-ethylhexyl)-4H-cyclopenta[2,1-b:3,4-b']dithiophene-2,6-diyl]] (PCPDTBT), squaraines (e.g. hydrazone end-capped symmetric squaraine with glycolic functionalization or diazulene squaraine), (PTT) (polythieno[3,4-b]thiophene), poly(5,7-bis(4-decanyl-2-thienyl)-thieno(3,4-b)diathiazole-thiophene-2,5) (PDDTT); diketopyrrolopyrrole-based polymers like poly{2,2'-[(2,5-bis(2-hexyldecyl)-3,6-dioxo-2,3,5,6-tetrahydropyrrolo[3,4-c]pyrrole-1,4-diyl)dithiophene]-5,5'-diyl-alt-thiophene-2,5-diyl} (PDPP3T), poly[[2,5-bis(2-hexyldecyl-2,3,5,6-tetrahydro-3,6- dioxopyrrolo[3,4 c]pyrrole-1,4-diyl]-alt-[3',3"-dimethyl- 2,2':5',2"- terthiophene]-5,5"-diyl] (PMDPP3T) and the Poly{2,2'-[(2,5-bis(2-hexyldecyl)-3,6-dioxo-2,3,5,6-tetrahydropyrrolo[3,4-c]pyrrole-1,4-diyl)dithiophene]-5,5'-diyl-alt-terthiophene-2,5-diyl} (PDPP5T), poly[2,6-4,8-di(5-ethylhexylthienyl)benzo[1,2-b;3,4- b]dithiophene-alt-5-dibutyloctyl-3,6-bis(5-bromothiophene-2-yl)pyrrolo[3,4-c]pyrrole-1,4-dione] (PBDTT-DPP); dithienosilole-based polymers like poly[(4,4-bis(2-ethylhexyl)dithieno[3,2-b:2',3'-d]silole)-2,6-diyl-alt-(4,7-bis(2-thienyl)-2,1,3-benzothiadiazole)-5,5'-diyl] (PSBTBT), 7,7'-(4,4-bis(2-ethylhexyl)-4H-silolo[3,2-b:4,5-b']dithiophene-2,6-diyl)bis(6-fluoro-4-(5'-hexyl-[2,2'-bithiophene]-5-yl)benzo[c][1,2,5]thiadiazole) (p-DTS(FBTTh₂)₂), poly[2,7-(9,9-dioctyl-dibenzosilole)-alt-4,7-bis(thiophene-2-yl)benzo-2,1,3-thiadiazole] (PSiFDTBT), benzodithiophene-based polymers like poly[4,8-bis[(2-ethylhexyl)oxy]benzo[1,2-b:4,5-b']dithiophene-2,6-diyl-alt-3-fluoro-2-[(2-ethylhexyl)carbonyl]thieno[3,4-b]thiophene-4,6-diyl] (PTB7), poly[(2,6-(4,8-bis(5-(2-ethylhexyl)thiophene-2-yl)-benzo[1,2-b:4,5-b']dithiophene))-alt-(5,5-(1',3'-di-2-thienyl-5',7'-bis(2-ethylhexyl)benzo[1',2'-c:4',5'-c']dithiophene-4,8-dione))]) (PBDB-T), poly{2,6'-4,8-di(5-ethylhexylthienyl)benzo[1,2-b;3,4-b]dithiophene-alt-5-dibutyloctyl-3,6-bis(5-bromothiophene-2-yl)pyrrolo[3,4-c]pyrrole-1,4-dione (PBDTT-DPP), poly[4,8-bis(5-(2-ethylhexyl)thiophene-2-yl)benzo[1,2-b;4,5-b']dithiophene-2,6-diyl-alt-(4-(2-ethylhexyl)-3-fluorothieno[3,4-b]thiophene-)-2-carboxylate-2-6-diyl)] (PBDTT-FTTE), poly[(4,8-bis-(2-ethylhexyloxy)-benzo(1,2-b:4,5-b')dithiophene)-2,6-diyl-alt-(4-(2-ethylhexanoyl)-thieno[3,4-b]thiophene-)-2-6-diyl)] (PBDTTT-C-F), PolyBenzoThiadiaZol(Thiophene)-stat-BenzoDiThiophene(Thiophene)-8 (PBTZT-stat-BDTT-8) and other polymers and copolymers and small molecules with absorption maximum between 320-800 nm; polytriarylamines and derivatives, poly[[2,5-bis(2-octyldodecyl)-2,3,5,6-tetrahydro-3,6-dioxopyrrolo[3,4-c]pyrrole-1,4-diyl]-alt2[[2,2'-(2,5-thiophene)bisthieno[3,2-b]thiophene]-5,5'-diyl]] (DPP(P)}, polyaniline (PANI), poly[(4,8-bis-(2-ethylhexyloxy)-benzo(1,2-b:4,5-b')dithiophene)-2,6-diyl-alt-(4-(2-ethylhexanoyl)-thieno[3,4-b]thiophene)-2-6-diyl)] (PBDTTT-C), poly[N29-hepta-decanyl-2,7-carbazole-alt-3,6-bis-(thiophen-5-yl)-2,5-dioctyl-2,5-dihydropyrrolo[3,4-]pyrrole-1,4-dione] (PCBTDPP), poly[[9-(1-octylnonyl)-9H-carbazole-2,7-diyl]-2,5-thiophenediyl-2,1,3-benzothiadiazole-4,7-diyl-2,5-thiophenediyl] (PCDTBT), poly[2,5-bis(2-octyldodecyl)pyrrolo[3,4-c]pyrrole-1,4(2H,5H)-dione-(E)-1,2-di(2,2'-bithiophen-5-yl)ethene] (PDPPDBTE), perfluoro(4-methyl-3,6-dioxaoct-7-en)sulfonylfluoride (PFI), poly(4-styrene sulfonate)-graft-polyaniline (PSS-g-PANI);; 2'-butyloctyl-4,6-dibromo-3-fluorothieno[3,4-b]thiophene-2-carboxylate (TT-BO), 3',4'-dichlorobenzyl-4,6-dibromo-3-fluorothieno-[3,4-b]thiophene-2-carboxylate (TT-DCB), and 2,6-bis(trimethyl-tin)-4,8-bis(2-ethylhexyloxy)benzo[1,2-b:4,5-b']dithiophene (BDT-EH) copolymer (PTB-DCB21), N2,N2,N2',N2',N7,N7,N7',N7'-octakis(4-methoxyphenyl)-9,9'-spirobi[9H-fluorene]-2,2',7,7'-tetramine (spiro-OMeTAD), poly[(9,9-dioctylfluorenyl-2,7-diyl)-co-(4,4'-(N-(4-sec-butylphenyl)diphenylamine)] (TFB), N4,N4'-di(naphthalene-1-yl)-N4,N4'-bis(4-vinylphenyl)biphenyl-4,4'-diamine (VNPB), 1,4-bis(4-sulfonatobutoxy)benzene and thiophene moieties (PhNa-1T)); metal oxides like NiOx, MoOx, etc....

While in the first layer it is preferred that the tiles are butted, with no gaps between them, it is not excluded that the first layer comprises gaps between the tiles. In such embodiments, it is preferred that the gaps are filled with a material comprising at least a second semiconductor and/or at least a second perovskite.

If gaps are present, it is preferred that the gaps between the tiles are fully filled (as also discussed above), so that no dead zone, i.e. zones not sensitive and thus not contributing to the image, remains. However, it is not excluded that a small amount of the gaps is not totally filled, e.g. if a further layer, e.g. an interlayer, is arranged on top of the first layer. In such a case less than 10 vol.%, preferably less than 5 vol.%, particularly less than 1 vol.% of the gaps may not be filled. If the whole gaps are filled, the thickness of the material in the gaps is then preferably essentially the same as the thickness of the tiles.

According to certain embodiments, the gap size g between the tiles depends on the pixel pitch P_{g}. According to certain embodiments, the following applies:
*P*_{g}/100 ≤ *g* ≤ *P*_{g}*1000; preferably P*_{g}*/10 ≤ *g* ≤ *P_{g}**100; more preferably *P_{g}* ≤ *g* ≤ *P_{g}**10

According to certain embodiments, the gaps between the tiles have a width of 0.1 pixel pitches to 50 pixel pitches, wherein a pixel pitch has a length of between and including 10 µm and 1000 µm.

According to certain embodiments, gaps between tiles are filled with a material comprising at least a second semiconductor and/or at least a second perovskite, e.g. in liquid form, as paste or as solid. After a recrystallization (when using e.g. liquidized perovskite), solvent removal (e.g. when using a paste), etc., a layer comprising the at least second semiconductor and/or the at least second perovskite remains, that can contribute to the signal in the pixels below.

According to certain embodiments, it is ensured that the material comprising at least a second semiconductor and/or at least a second perovskite completely fills the gaps, e.g. using liquefied perovskite and/or a paste. This is comparable (figuratively) to a case where jointing mortar is applied between tiles, particularly deep into the gaps. The laser cut edges of the tiles therein enable a good filling of the gaps, as uneven surfaces on the tile edges can be minimized or even avoided using pulsed laser cutting. Thus, a signal of filled edges can even further be improved.

The material comprising at least a second semiconductor and/or at least a second perovskite in the gaps is not particularly restricted if a second semiconductor and/or at least a second perovskite is contained. According to certain embodiments, the material comprising at least a second semiconductor and/or at least a second perovskite in the gaps essentially consists of (meaning that at least 95 wt.%, at least 99 wt.% or even 99.9 wt.% of the material are the at least first semiconductor and/or first perovskite) or even consists of the at least second semiconductor and/or second perovskite. According to certain embodiments, the material comprising at least a second semiconductor and/or at least a second perovskite in the gaps only comprises a second semiconductor and/or a second perovskite, although it is not excluded that the second semiconductor and/or second perovskite are present as mixtures of second semiconductors and/or second perovskites. Apart from the second semiconductor and/or second perovskite, further materials like binders may be contained, though, in an amount of up to 30 wt.%, preferably up to 30 wt.%, further preferably up to 10 wt.%, even further preferably up to 5 wt.%, in relation to the material comprising at least a second semiconductor and/or at least a second perovskite.

The second semiconductor may be the same as or different from the first semiconductor, e.g. chosen from the ones described above, and/or the second perovskite may be the same as or different from the first perovskite, e.g. chosen from the ones described above. According to certain embodiments, the second semiconductor is the same as the first semiconductor, and/or the second perovskite is the same as the first perovskite.

As some perovskites are also semiconductors, there is also an overlap between the possible materials of the second semiconductor and the second perovskite. According to certain embodiments, the gaps are filled with a material comprising at least a second perovskite, which is particularly advantageous when the material absorbing and converting the electromagnetic radiation comprises a first perovskite, which may be the same as the second perovskite or may be different.

The second perovskite may particularly be applied as liquefied perovskite and hardened, as paste, or as powder, and/or the second semiconductor may be applied as paste and/or as powder. If the material is applied as paste or as powder, suitable additives may be contained, e.g. at least a solvent and/or at least a binder.

A liquefying of the second perovskite is e.g. possible using methylamine (MA) gas, particularly in the case of methylammonium ions in the second perovskite. The process is e.g. described in EP 20155403.7 or Li, C., S. Pang, H. Xu und G. Cui. Methylamine gas based synthesis and healing process toward upscaling of perovskite solar cells: Progress and perspective. Solar RRL, 1(9), 1700076 (2017), wherein reference is made to both with regard to liquefying perovskites with methylamine gas. Due to the MA gas, the perovskite can be liquefied and subsequently be recrystallized, e.g. with changed morphology, as soon as the MA gas is not anymore in the atmosphere. After removing the methylamine gas, the perovskite can thus be recrystallized in gaps according to certain embodiments of the present method, respectively be present in recrystallized form according to certain embodiments of the detector. Particularly, in such a case it is preferred that the second perovskite comprises an alkyl ammonium cation, wherein the alkyl groups have 1 to 4 C-atoms, particularly a methyl ammonium cation.

In such a case, it also may be possible to fill a precursor, e.g. lead iodide of the perovskite and then crystallize it, as e.g. described in EP 3304611 B1.

For the application of a paste, the at least one second semiconductor and/or the at least one second perovskite may be present in the form of particles, which may be suitably mixed with at least one binder and/or at least one solvent. For this purpose, the particles, e.g. in the form of powder, may be dispersed in a suitable solvent, optionally while adding at least one binder. Suitable pastes for application are e.g. described in US 20120181440 A1 and EP 3376260 A1.

In the paste the size of the particles is not particularly restricted and may be e.g. in a range of between and including 0.01 and 600 µm, i.e. also encompass quantum dots and/or nano crystals, e.g. be in a range of between and including 1 and 300 µm, e.g. as measured by sieve analysis or laser diffraction.

If the paste contains at least one binder, the binder is not particularly restricted, and may e.g. be chosen from suitable polymeric resins, e.g. polyvinyl butyral (PVB) resin, an acryl resin, a phenoxy resin, a polyester resin, a polyvinyl formal resin, a polyamide resin, a polystyrene resin, a polycarbonate resin, a polyvinyl acetate resin, a polyurethane resin, an epoxy resin, a polyimide resin, a polyvinyl alcohol resin, a polyethylene resin, a polyester resin, a polycarbonate resin, and any mixtures thereof. The binder amount may be suitably set, based e.g. on the binder, and may be in a range of equal to or less than 30 wt.%, equal to or less than 20 wt.%, and/or more than 1 wt.%, e.g. more than 2 wt.%, based on the total amount of the paste.

If a solvent is contained in the paste, it is not particularly restricted, and may be suitably chosen, e.g. depending on the binder, e.g. from the list dipropylene glycol monomethyl ether (DPGME), butyl cellosolve (BC), γ-butyrolactone, N-methyl-2-pyrrolidone, N,N-dimethylformamide, butyl cellosolve acetate (BCeA), KOCOSOL, butyl cellosolve (BC), ethyl 3-ethoxypropionate (EEP), and mixtures thereof. The amount of solvent, if contained, may be in a range of 1 wt.% to 60 wt.%, e.g. 2 wt.% to 50 wt.%, e.g. 3 wt.% to 40 wt.%, based on the total mass of the paste. In addition, the paste may further include additives such as a dispersant, an antifoaming agent, and a leveling agent.

In case the material in the gaps comprising the at least one second semiconductor and/or the at least one second perovskite is applied as a powder, it may be just applied as a powder of particles of the at least one second semiconductor and/or the at least one second perovskite, with the particles e.g. having a size in a range of between and including 0.01 and 600 µm, e.g. in a range of between and including 1 and 300 µm, as described above with regard to the paste. In such case the powder may just be filled, but can also be compacted, glued together using a suitable resin, etc.

According to certain embodiments, the material in the gaps is filled as a liquefied perovskite that is recrystallized and/or as a paste comprising the at least one second semiconductor and/or the at least one second perovskite.

If the second perovskite and the first perovskite are used and are the same, the tiles still can be distinguished from the material in the gaps, though, due to the manufacturing process. Differences can be found in the morphology of the respective layer at the location of the tiles and in the gaps, e.g. regarding grain sizes, grain boundaries, density, porosity, etc. Thus, the tiles and material in the gaps can be clearly distinguished, even if the same material is used, e.g. regarding the morphology and/or the inside, which is due to the difference in production thereof. As a consequence, also the electric signal, respectively the sensitivity, may be different when comparing the tiles and the material in the gaps, even if the same chemical material is used, due to difference in morphology, etc.

According to certain embodiments, the detector further comprises a second layer between the first, pixelated electrode layer and the first layer, wherein the second layer is an adhesion promoting layer, preferably wherein the second layer comprises at least a third semiconductor and/or a conductor and/or a third perovskite, optionally the detector for electromagnetic radiation comprising at least one interlayer between the first, pixelated electrode and the second layer and/or between the second layer and the first layer.

The thickness of the second layer is not particularly restricted and may be in a range of between 100 nm and 1000 µm, e.g. between 200 nm and 500 µm, e.g. between 300 nm and 100 µm.

According to certain embodiments, the second layer is an anisotropic conductive film (ACF) or anisotropic conductive paste (ACP), which, may, however, according to certain embodiments, need an additional structured electrode on the respective absorber tile, and/or call for a good alignment between the electrodes on the tile and those in the first, pixelated electrode layer, e.g. on the backplane (substrate).

According to certain embodiments, the second layer comprises at least a third semiconductor and/or a conductor and/or a third perovskite.

According to certain embodiments, the second layer comprises a conductor, which is not particularly restricted, e.g. in the form of bump bonds. These bump bonds are not particularly restricted and may be made e.g. of a suitable metal, e.g. a conductive metal like Cu, Ag, Pb, Sn, In etc., as well as alloys thereof, and/or may be made in any suitable form, e.g. in the form of balls, spheres, semi-spheres, pillars, columns, cubes, etc. According to certain embodiments, the bump bonds may further be in contact with a glue, which can be e.g. introduced by an underfill process, etc., but it is also not excluded that the bump bonds are just surrounded by air, etc.

According to certain embodiments, the second layer comprises or even consists of the third perovskite, which may be the same as the first and/or second perovskite or be different. In such instance the second layer may be produced, respectively applied, as liquefied perovskite, as laid out regarding the second perovskite, and recrystallized, and/or be applied with a paste, and dried. According to certain embodiments, the second layer is made from a recrystallized perovskite, that was liquefied, e.g. with MA gas, as described above.

The third perovskite thus is not particularly restricted and may contain any organic, inorganic and/or organic-inorganic perovskite, as well as mixtures thereof, as defined above with regard to the first perovskite.

According to certain embodiments, the detector for electromagnetic radiation comprises at least one interlayer between the first, pixelated electrode and the second layer and/or between the second layer and the first layer, wherein the respective interlayer can be as described above. According to certain embodiments, no interlayer is present between the first layer and the second layer.

According to certain embodiments, the second layer is a structured layer comprising a structure and a material comprising the third semiconductor and/or the conductor and/or the third perovskite filled at least in the structure and/or surrounding the structure. In such embodiments, the structure is not particularly restricted, and can be in the form of a grid, pillars, etc. The structure therein can serve as an anchor structure, which can increase the bond between the first, pixelated electrode layer and the second layer. According to certain embodiments, the structure is as high as the further material of the second layer, or the further material, e.g. the third semiconductor and/or the conductor and/or the third perovskite, surpasses the structure, e.g. for at least 10 nm, at least 100 nm, or even 1 µm, or even 10µm, or even 30 µm. The grid can be suitably arranged on e.g. the first, pixelated electrode layer, using e.g. resists, laser cutting, welding, etc., for producing the structure. Suitable structures are e.g. described in EP 20155403.7, to which reference is made with regard to the structures.

In a second aspect, the present invention relates to a method of producing a detector for electromagnetic radiation, particularly an X-ray and/or gamma detector, comprising:
- providing a first, pixelated electrode layer comprising a multitude of electrode pixels,
- optionally applying a second layer on the first, pixelated electrode layer, wherein the second layer is an adhesion promoting layer, preferably wherein the second layer comprises at least a third semiconductor and/or a conductor and/or a third perovskite,
- preparing a multitude of tiles comprising a material absorbing and converting the electromagnetic radiation,
- cutting at least part of edges of the tiles comprising a material absorbing and converting the electromagnetic radiation using pulsed laser cutting, particularly edges that will be facing each other during further production of the detector
- applying the multitude of tiles comprising a material absorbing and converting the electromagnetic radiation on the first, pixelated electrode layer or on the optional second layer, particularly in a way that edges cut by pulsed laser cutting are facing each other, and
- applying a second electrode layer, on the first layer.

With the present method, particularly the detector for electromagnetic radiation of the present invention can be produced. Thus, certain embodiments discussed with regard to the present detector for electromagnetic radiation also apply to the present method, and vice versa. According to certain embodiments, the steps are carried out in the order given for the present method. However, some steps may be also carried out at a different time, i.e. out of order, e.g. the steps of preparing a multitude of tiles comprising a material absorbing and converting the electromagnetic radiation, and cutting at least part of edges of the tiles comprising a material absorbing and converting the electromagnetic radiation using pulsed laser cutting, particularly edges that will be facing each other during further production of the detector, may be carried out at an earlier time.

In the present method, the step of providing a first, pixelated electrode layer comprising a multitude of electrode pixels is not particularly restricted, and a first, pixelated electrode layer may be provided, as described above with regard to the present detector.

Also, the step of optionally applying a second layer on the first, pixelated electrode layer, wherein the second layer is an adhesion promoting layer, preferably wherein the second layer comprises at least a third semiconductor and/or a conductor and/or a third perovskite, is not particularly restricted. As described above the second layer can be applied e.g. as liquefied third perovskite and recrystallized, as paste and hardened, etc., and can then have a final thickness in a range of between 100 nm and 1000 µm, e.g. between 200 nm and 500 µm, e.g. between 300 nm and 100 µm.

According to certain embodiments, applying the second layer comprises applying a structure, and filling and/or surrounding a material comprising a third semiconductor and/or a conductor and/or a third perovskite at least in the structure and/or around the structure, which may be as described with regard to the present detector. The applying of the structure is not particularly restricted and can be done using photolithography, welding, laser cutting, atomic layer deposition, etc., e.g. as also described above with regard to the detector. When the structure is applied, it can then be filled and/or surrounded (e.g. when the structure comprises pillars) by the material comprising a third semiconductor and/or a conductor and/or a third perovskite, e.g. by applying liquefied perovskite and recrystallization, applying a paste, etc.

In addition, also the step of preparing a multitude of tiles comprising a material absorbing and converting the electromagnetic radiation is not particularly restricted. To obtain a suitable thickness of the tiles, they can be e.g. prepared by soft sintering, cutting single crystalline material, producing thick layers from paste, evaporating and/or sputtering of the material in thick layers, or aerosol, deposition, but also other methods are not excluded.

The step of cutting at least part of edges of the tiles comprising a material absorbing and converting the electromagnetic radiation using pulsed laser cutting, particularly edges that will be facing each other during further production of the detector, is also not particularly restricted, as long as the cutting is carried out using pulsed laser cutting.

The inventors found that pulsed laser cutting achieves removing material of the tiles, particularly the material absorbing and converting the electromagnetic radiation, particularly inside the focal spot of the laser.

The pulsed laser is not particular restricted, but preferably is a laser providing short laser pulses, e.g. a nano-, pico-, or femtosecond laser. According to certain embodiments, the pulsed laser cutting is carried out with a nano-, pico-, or femtosecond laser, particularly a pico- or femtosecond laser, particularly with pulse durations in the range of 500 picoseconds or less and 1 femtosecond or more, e.g. 100 picoseconds or less and 10 femtoseconds or more, e.g. 20 picoseconds or less and 200 femtoseconds or more. It was especially found that with lasers with very short pulse durations it is possible to cut materials even if the wavelength of the laser is above the bandgap of the material. Particularly with such a laser the amount of energy introduced to the material around the cutting edge can be minimized, thus minimizing any changes to the material of the absorber tiles. However, the laser pulses are sufficient to remove the material slowly but steadily. By adjusting of laser parameters a cut can be performed through thick layers of several hundred micrometers to millimeters. The cut is represented by a vertical cut where the porosity of the material, particularly a perovskite, can be improved.

Cutting by a pulsed laser also can realize any cutting geometry, thus being able to adjust the tiles to different detector surfaces and/or pixel sizes of the backplane, etc. The precision of the cut and thus the precision of the edge can be in the range of a few micrometers, as indicated above, this way avoiding inhomogeneities in the detector image, i.e. areas of different sensitivity, which for an X-ray detector can be around 50-300 µm in the area of edges. The material used in the laser as well as the profile of the laser is not particularly restricted. For example, the laser may have a Gauss profile, but also any other laser profile is suitable. Further, the material of the wavelength, e.g. determining the laser wavelength, may also depend on the material to be cut, particularly the material absorbing and converting the electromagnetic radiation. However, also a laser with a wavelength that is too short may damage the material due to an absorption to strong. According to certain embodiments, the laser has a wavelength of at least 500 nm, preferably at least 700 nm, particularly at least 800 nm, e.g. at least 1000 nm. For example, MAPI may be effectively cut with a laser wavelength of at least 800 nm, e.g. with a laser having a wavelength of 1064 nm. According to certain embodiments, the laser has a pulse repetition frequency between and including 50 Hz and 100 MHz, e.g. between and including 100 Hz and 75 MHz, e.g. between and including 500 Hz and 10 MHz, e.g. between and including 1 kHz and 85 KHz.

According to certain embodiments, the pulsed laser cutting is carried out with a laser having a focal point size of between and including 0.1 to 1000 µm, preferably between and including 1.0 to 100 µm, further preferably between and including 1.0 and 50 µm, and/or with a line number nL of 1 to 1000, preferably 2 to 100, more preferably 5 to 30, and/or a laser peak fluence F0 (energy per area of material to be cut) of between and including 0.1 to 100.0 J/cm², preferably between and including 0.2 to 10.0 J/cm², further preferably between and including 0.27 to 4.0 J/cm². Particularly, it was found that a laser peak fluence F0 that is too low will not achieve sufficient removal of material, thus making the process too long and expensive, while a too high laser peak fluence may result in material decomposition also around the edge, leading to edges with worse surfaces and/or the formation of pristine precursor material at the edges, e.g. PbI₂ and MAI in the case of MAPI.

According to certain embodiments, laser cutting is carried out by scanning across the tiles repeatedly. It was found that particularly good results can be obtained if the scanning is carried out in parallel lines to that a sufficiently deep cut can also be obtained easily for very thick materials. According to certain embodiments, the line number of parallel scan lines nL is 1 to 1000, preferably 2 to 100, more preferably 5 to 30.

Furthermore, also optimal numbers of overlap of laser spots have been found for the focal spot during scanning, wherein a preferred overlap in x-direction (scanning direction) Ωx is between and including 10% and 90%, preferably between and including 30% and 85%, further preferably between and including 50% and 85%, and/or a preferred overlap in y-direction (of parallel lines) Ωy is between and including 5% and 80%, preferably between and including 10% and 60%, further preferably between and including 20% and 50%. Particularly, according to certain embodiments, the overlap in y-direction is preferably smaller, in order to minimize energy input with a homogeneous removal of material.

The number of crossings n over the tiles is not particularly restricted and may depend on the material to be cut, the thickness of the tile, etc. The number may also depend on the material removal rate, which can be e.g. at least 50 nm per pulse, e.g. at least 100 nm per pulse, and/or can be e.g. up to 2.5 µm per laser pulse, and/or can even sum up to a depth of e.g. 5.0 to 15 µm (depending on overlap), e.g. 9.1 µm per scan line, e.g. with an overlap Ωx of 80%, when cutting MAPI. The scan speed of the laser of the laser is not particularly restricted. For example, a suitable scanning speed may be between and including 1 and 5000 mm/s, preferably between and including 10 and 1000 mm/s, further preferably between and including 50 and 400 mm/s.

Furthermore, the step of applying the multitude of tiles comprising a material absorbing and converting the electromagnetic radiation on the first, pixelated electrode layer or on the optional second layer, particularly in a way that edges cut by pulsed laser cutting are facing each other, is not particularly restricted either, and the tiles can be suitably attached, e.g. by pressing, gluing, or also by putting it on a layer below before it is hardened, e.g. the second layer before recrystallization or hardening.

According to certain embodiments, the tiles in the first layer comprise at least a first semiconductor and/or a first perovskite, preferably at least a first perovskite, as the material absorbing and converting the electromagnetic radiation, particularly as described with regard to the present detector.

According to certain embodiments, the tiles have a size in the range of 1x1 cm² to 50x50 cm², preferably between and including 5x5 cm² to 50x50 cm², further preferably between and including 10x10 cm² to 50x50 cm².

According to certain embodiments, the number of tiles in the first layer is between and including 2 and 1000, preferably between and including 2 and 100, more preferably between and including 2 and 50, even more preferably between and including 2 and 10.

According to certain embodiments, two adjacent tiles in the first layer have a tilt angle between tiles between and including 0° and 5°.

Furthermore, the thickness of the tiles is not particularly restricted and can be e.g. between and including 10 µm to 50000 µm, preferably between and including 25 to 10000 µm, further preferably between and including 50 µm to 3000 µm, further preferably between and including 70 µm to 2000 µm, even further preferably between and including 100 µm and 1500 µm, e.g. between and including 100 µm and 1000 µm.

According to certain embodiments, the tiles have a size in the range of 1x1 cm² to 50x50 cm² and a thickness of between and including 10 µm to 50000 µm.

According to certain embodiments, the multitude of tiles are butted.

Finally, the step of applying a second electrode layer, on the first layer is not particularly restricted.

According to certain embodiments, a surface layer, e.g. glass and/or an encapsulation, may be applied on the second electrode layer, opposite to the first layer, for protection, which is not particularly restricted.

According to certain embodiments, gaps may be comprised between two adjacent tiles. According to certain embodiments, no gaps may be present between two adjacent tiles. If one or more gap is present, it may be filled with a material comprising at least a second semiconductor and/or at least a second perovskite, particularly as described with regard to the present detector, in the gaps until the gaps are filled, wherein the tiles and the filled gaps may then form the first layer.

According to certain embodiments, gaps that may be present are filled with a liquid material, a paste or a powder comprising at least the second semiconductor and/or at least the second perovskite. The material comprising at least a second semiconductor and/or at least a second perovskite can be in the form of a liquid, e.g. as a solution, liquid semiconductor or liquefied perovskite, paste, or solid - e.g. in the form of a powder, as described above, and be filled in the gaps using a suitable applicator, e.g. a dispensing apparatus. According to certain embodiments, the applicator which e.g. fills a liquid semiconductor and/or liquefied perovskite and/or a solution comprising the at least second semiconductor and/or the at least second perovskite, in the gaps between tiles is a dispensing robot, which optionally can be controlled by an artificial intelligence with automatic detection of the gaps and filling thereof. According to certain embodiments, the material comprising at least a second semiconductor and/or at least a second perovskite, e.g. in the form of a liquid, can also be applied in several steps, e.g. layer by layer, to suitably fill the gaps and/or achieve a desired layer thickness.

According to certain embodiments, the method further comprises applying at least one interlayer between the first, pixelated electrode layer and the optional second layer, and/or between the optional second layer and the first layer, or between the first, pixelated electrode layer and the first layer; and/or between the first layer and the second electrode layer.

An exemplary method of the present invention is schematically shown in Figure 18.

In the method shown in Figure 18, a step of providing a first, pixelated electrode layer comprising a multitude of electrode pixels 11 is followed by an optional step of applying a second layer on the first, pixelated electrode layer 12, wherein the second layer is an adhesion promoting layer, s step of preparing a multitude of tiles comprising a material absorbing and converting the electromagnetic radiation 13, a step of cutting at least part of edges of the tiles comprising a material absorbing and converting the electromagnetic radiation using pulsed laser cutting 14, particularly edges that will be facing each other during further production of the detector, a step of applying the multitude of tiles comprising a material absorbing and converting the electromagnetic radiation on the first, pixelated electrode layer or on the optional second layer 15, particularly in a way that edges cut by pulsed laser cutting are facing each other, and a step of applying a second electrode layer on the first layer 16.

The above embodiments can be combined arbitrarily, if appropriate. Further possible embodiments and implementations of the invention comprise also combinations of features not explicitly mentioned in the foregoing or in the following with regard to the Examples of the invention. Particularly, a person skilled in the art will also add individual aspects as improvements or additions to the respective basic form of the invention.

The present invention will now be described in detail with reference to several examples thereof. However, these examples are illustrative and do not limit the scope of the invention.

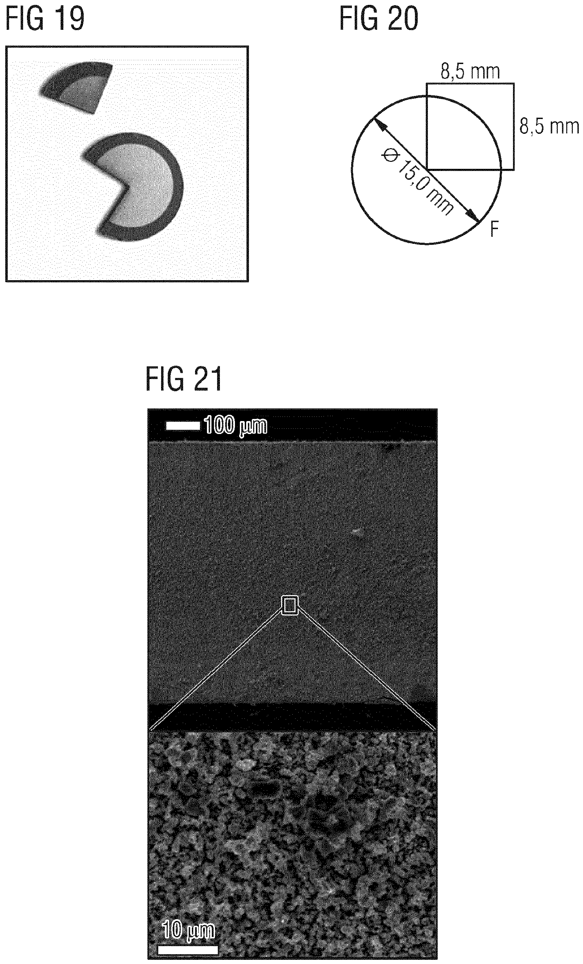

A circular sample of a MAPI wafer having a diameter of 15 mm and a height of about 750 µm was produced using a circular pressing tool. A section of the wafer was then cut using pulsed laser cutting, and an image of the cut wafer is shown in Figure 19. The laser cut geometries can be seen in the schematic of Figure 20. The laser cut sample was made with a 1064 nm picosecond laser with a round focal spot having a diameter (focal spot size) of 30 µm with the following parameters: F0= 2 J/cm², fp=20 kHz, Ωy=33,3%, Ωx=80%, nL=18, n=70, pulse duration 10 ps. These parameters were found, after some initial tests, to be optimized regarding the avoidance of decomposition of the material during cutting outside the focal spot, avoiding material decomposition of the MAPI to PbI₂ or MAI outside the focal spot. Parameters like using a too high energy, too small focal spot, etc. were found to decompose the material too much.

Cross-sectional SEM images of the cut surface can be seen in Figure 21. The MAPI wafer shows a smooth edge with a single powder lump on it. This lump can be removed e.g. with a suitable tissue material or other methods. The zoom into the MAPI cross-section shows homogenous distribution of grains with diameters between 1-5 µm. The crystal structure is clear visible.

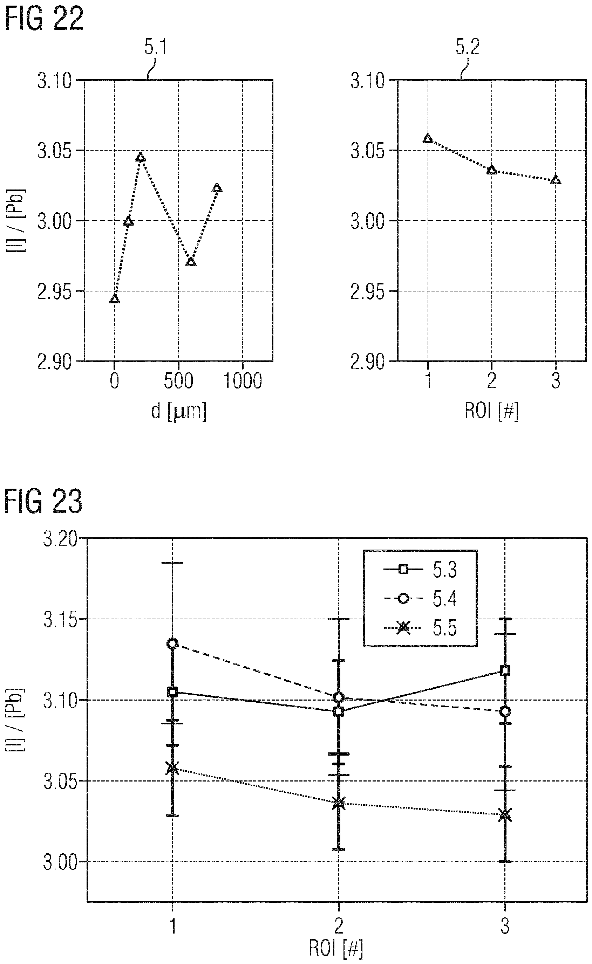

Figures 22 and 23 show a compositional analysis of laser cut perovskite samples using EDX (energy dispersive X-ray spectroscopy). Within the scope of measurement accuracy, the EDX analysis in Figure 22 shows that the relation of I⁻ to Pb²⁺ ([I]/[Pb]) in the laser cut sample 5.1 at the edge is in the same range as in a region of the pure sample 5.2 at an edge that has not been irradiated by the laser. In Figure 22, the ratio [I]/[Pb] is plotted for the laser cut sample 5.1 against the distance d from the edge, and for the pure sample 5.2 for different regions of interest (ROI). The laser cut sample 5.1 shows also no significant change of chemical composition in dependency of the distance to the cut edge. If the perovskite (MAPI) would have been degraded, lead iodide (PbI₂) would be measurable, with a change of the relation of I⁻ to Pb²⁺ from 3 to 2, which is observed when continuous laser cutting is applied (data not shown). Also, for too long laser pulses, e.g. longer than 1 ns, an increased degradation of material may be observed, however not as detrimental as the degradation with a continuous laser. In Figure 23, also no change in the composition can be seen for two reference samples, a first reference sample 5.3 and a second reference sample 5.4, both being obtained by breaking MAPI at different locations, in comparison to a further laser cut sample 5.5, measured at a location different from laser cut sample 5.1. The error bars of the measurements of the different samples overlap.

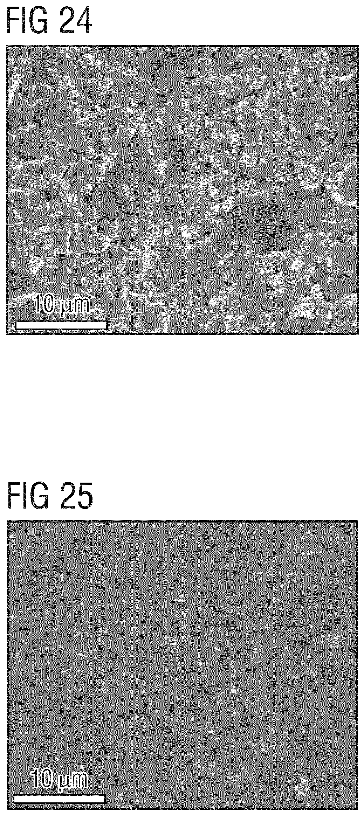

A difference of a reference MAPI sample (here pure sample 5.2) and a laser cut sample can be seen in the morphology, as seen in the SEM images shown in Figures 24 and 25: The SEM image of the reference sample in Figure 24 shows a higher porosity and more defined crystal structures compared to the laser cut sample in Figure 25. It is assumed that crystal growth may be triggered due to the energy transfer of the laser irradiation to the perovskite, resulting in bigger crystals and smaller porosity.

### Example 2

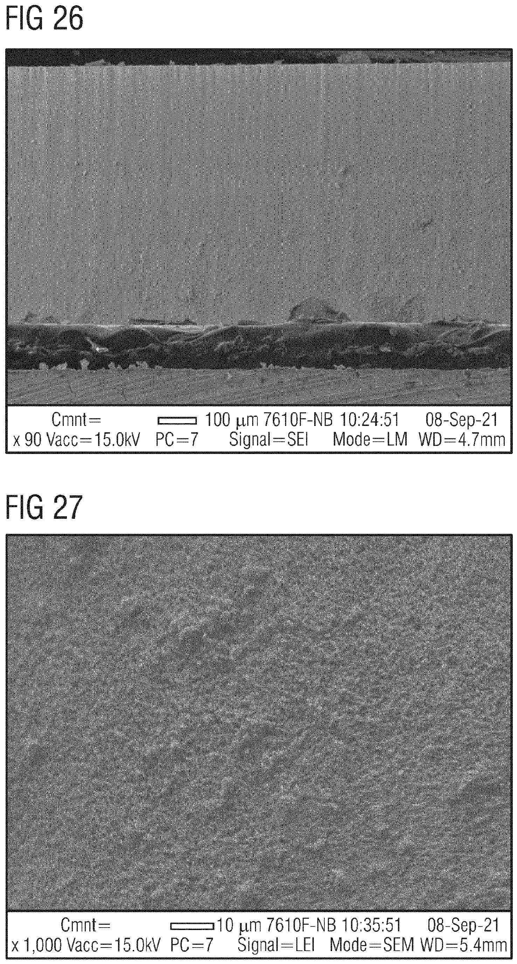

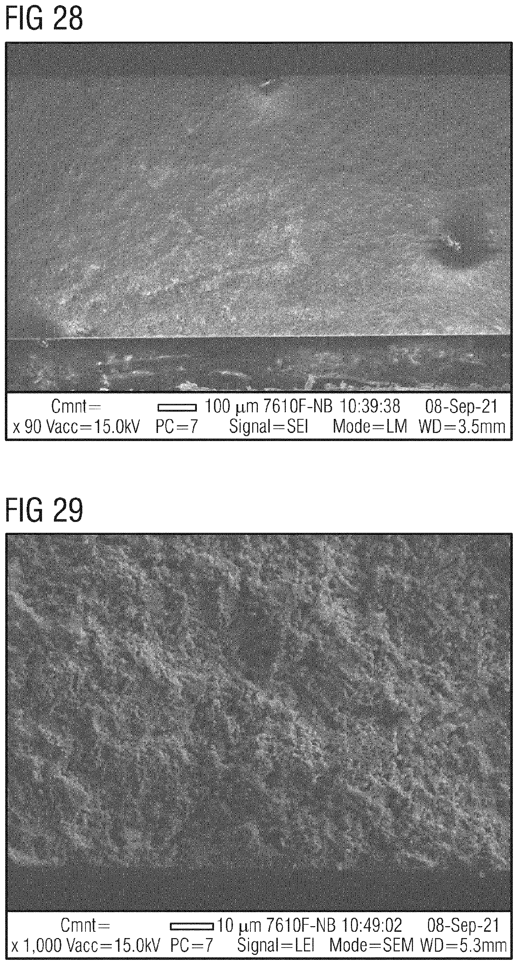

In order to further show the advantage of the present method using pulsed laser cutting, a comparison of a laser-cut sample as in Example 1 was made with a sample in which the edge was manually broken with tweezers. Figures 26 to 29 show cross-section SEM of the respective samples, with Figures 26 and 28 showing data of upper secondary electron in-lens (SEI) measurement data of the laser cut and broken MAPI samples, respectively, and Figures 27 and 29 lower secondary electron in-lens (LEI) measurement data thereof.

As seen in the figures, the surface of the broken sample has a higher roughness than the laser cut sample. The cross section shows some deepenings and powder lumps. In the LEI images, the topography can be better seen, underlining the impression: The laser cut sample shows a smooth surface with homogenously arranged grains and a few protruding grains. The image of the reference sample is dominated by a wavy surface.

The present invention relates to the cutting of absorber layers of tiles for the production of detectors using such tiles using pulsed laser cutting. This enables the production of precise edges for the tiles, enabling better and easier production of the detector as well as improved signals for the detectors. Also, the use of smaller pressing tools and presses, and thus easier pressing, is possible, reducing the cost for tile production. The precision of the edges is significantly improved - together with a high quality of the edges with small surface roughness in the range of a few micrometers, and thus a reduction of free areas between tiles is possible, leading to improved image quality when using the detectors. Due to the pulsed laser cutting, also flexible geometries of the tiles can be produced, e.g. adapted to special, e.g. curved, detector surfaces, and at most minimal changes in material characteristics of the absorber layer are observed near the cut edges. In addition, laser cutting is a time-efficient process that does not require the additional and detrimental use of chemicals and can be easily automated, thus being adaptable for industrial production of detectors. The high-precision cutting of the absorber layers in the tiles further does not or only minimally influence the material and absorption characteristics, and particularly detrimental absorption characteristics at uncut edges and corners can be avoided. With cutting, it is thus possible to produce flat surface detectors with high sensitivity and resolution at low cost.

## Claims

1. A detector for electromagnetic radiation, particularly an X-ray and/or gamma detector, comprising:
- a first, pixelated electrode layer comprising a multitude of electrode pixels,
- a first layer comprising a multitude of tiles comprising a material absorbing and converting the electromagnetic radiation, wherein at least edges of tiles facing another tile have been cut using pulsed laser cutting, and
- a second electrode layer.

2. The detector for electromagnetic radiation of patent claim 1, wherein the tiles in the first layer comprise at least a first semiconductor and/or a first perovskite, preferably at least a first perovskite, as the material absorbing and converting the electromagnetic radiation.

3. The detector for electromagnetic radiation of patent claim 1 or 2, wherein the tiles have a size in the range of 1x1 cm² to 50x50 cm² and a thickness of between and including 10 µm to 50000 µm.

4. The detector for electromagnetic radiation of any one of the preceding patent claims, wherein the multitude of tiles are butted.

5. The detector for electromagnetic radiation of any one of the preceding patent claims, wherein the number of tiles is between and including 2 and 1000.

6. The detector for electromagnetic radiation of any one of the preceding patent claims, further comprising at least one interlayer between the first, pixelated electrode and the first layer and/or between the first layer and the second electrode layer.

7. The detector for electromagnetic radiation of any one of the preceding patent claims, wherein the first layer comprises gaps between the tiles, wherein the gaps are filled with a material comprising at least a second semiconductor and/or at least a second perovskite.

8. The detector for electromagnetic radiation of any one of the preceding patent claims, further comprising a second layer between the first, pixelated electrode layer and the first layer, wherein the second layer is an adhesion promoting layer, preferably wherein the second layer comprises at least a third semiconductor and/or a conductor and/or a third perovskite, optionally the detector for electromagnetic radiation comprising at least one interlayer between the first, pixelated electrode and the second layer and/or between the second layer and the first layer.

9. A method of producing a detector for electromagnetic radiation, particularly an X-ray and/or gamma detector, comprising:
- providing a first, pixelated electrode layer comprising a multitude of electrode pixels,
- optionally applying a second layer on the first, pixelated electrode layer, wherein the second layer is an adhesion promoting layer, preferably wherein the second layer comprises at least a third semiconductor and/or a conductor and/or a third perovskite,
- preparing a multitude of tiles comprising a material absorbing and converting the electromagnetic radiation,
- cutting at least part of edges of the tiles comprising a material absorbing and converting the electromagnetic radiation using pulsed laser cutting, particularly edges that will be facing each other during further production of the detector,
- applying the multitude of tiles comprising a material absorbing and converting the electromagnetic radiation on the first, pixelated electrode layer or on the optional second layer, particularly in a way that edges cut by pulsed laser cutting are facing each other, and
- applying a second electrode layer, on the first layer.

10. The method of patent claim 9, wherein the tiles in the first layer comprise at least a first semiconductor and/or a first perovskite, preferably at least a first perovskite, as the material absorbing and converting the electromagnetic radiation.

11. The method of patent claim 9 or 10, wherein the pulsed laser cutting is carried out with a laser having a focal point size of between and including 0.1 to 1000 µm, and/or with a line number nL of 1 to 1000, and/or a laser peak fluence of between and including 0.1 to 100 J/cm².

12. The method of any one of patent claims 9 to 11, wherein the tiles have a size in the range of 1x1 cm² to 50x50 cm² and a thickness of between and including 10 µm to 50000 µm.

13. The method of any one of patent claims 9 to 12, wherein the multitude of tiles are butted.

14. The method of any one of patent claims 9 to 13, wherein the number of tiles is between and including 2 and 1000.

15. The method of any one of patent claims 9 to 14, further comprising applying at least one interlayer between the first, pixelated electrode layer and the optional second layer, and/or between the optional second layer and the first layer, or between the first, pixelated electrode layer and the first layer; and/or between the first layer and the second electrode layer.
